# EUROPÄISCHE PATENTSCHRIFT

(11) **EP 2 228 138 B1**
(45) Veröffentlichungstag und Bekanntmachung des Hinweises auf die Patenterteilung: **21.08.2013**
(21) Anmeldenummer: 10155771.8
(22) Anmeldetag: 08.03.2010
(51) Int. Cl.: B05B 7/06, H05K 3/00, B05C 11/10

(54) **Vorrichtung zum Beschichten eines Substrats**
Device for coating a substrate
Dispositif de revêtement d'un substrat

(30) Priorität: 09.03.2009 DE 102009013379
(43) Veröffentlichungstag der Anmeldung: 15.09.2010
(73) Patentinhaber: Klingel, Wolfgang, D-71292 Friolzheim (DE)
(72) Erfinder: Klingel, Wolfgang, 71292, Friolzheim (DE)
(74) Vertreter: Witte, Weller & Partner

(56) Entgegenhaltungen:
- EP-A2- 1 057 542
- DE-A1- 10 261 576
- US-A1- 2008 164 335
- US-B1- 6 270 019

## Beschreibung

Die vorliegende Erfindung betrifft eine Vorrichtung zum Beschichten eines Substrats, insbesondere einer Leiterplatte mit einer Einrichtung zum Auftragen (Materialauftragseinrichtung) eines Beschichtungsmaterials, insbesondere eines Schutzlacks, und einer Einrichtung zum Zuführen eines gasförmigen Mediums (Gas-Zuführeinrichtung), wobei die Materialauftragseinrichtung ein inneres rohrförmiges Element aufweist, wobei die Gas-Zuführeinrichtung ein äußeres rohrförmiges Element aufweist, das koaxial zu dem inneren rohrförmigen Element angeordnet ist und dieses umschließt, so dass ein Gas-Zuführkanal zwischen äußerem und innerem rohrförmigen Element ausgebildet wird, der an einem Ende eine ringförmige Öffnung aufweist, wobei der Zuführkanal so ausgestaltet ist, dass das gasförmige Medium parallel zu dem Beschichtungsmaterial durch die ringförmige Öffnung ausströmt, um beim Auftreffen auf dem Substrat das aufgebrachte Beschichtungsmaterial zu verdrängen und dadurch flächig zu verteilen.

Eine Vorrichtung der vorgenannten Art ist aus den Druckschriften DE 10261576 A1, EP 1057542 A2, US 2008/0164335 A1 bekannt.

Allgemein werden derartige Vorrichtungen dazu eingesetzt, bspw. Leiterplatten mit einem Schutzlack zu versehen. Eine wesentliche Problematik bei der Beschichtung von Leiterplatten mit einem Schutzlack besteht insbesondere darin, den Schutzlack zielgenau aufzutragen. Kleine Abweichungen oder Schutzlackspritzer können sehr schnell zu einer Verschmutzung von Kontakten führen, was sich später in Funktionsstörungen der Schaltung bemerkbar macht.

Allgemein werden häufig sog. Sprühverfahren eingesetzt, die mit unterschiedlich ausgeformten Sprühdüsen Lack beim Verlassen einer Düse zerstäuben. Ein luftunterstütztes Atomisieren des Lacks ergibt einen mittig geschlossenen, nach außen hin verarmenden Lackfilm unter Ausbildung von Sprühnebel und Spritzern. Diese Methode des Spritzens eignet sich wegen der in sich verlaufenden Übergänge besonders zum manuellen Spritzen mittels Farbspritzpistolen. Eine breite Überlappung der Spritzgänge ist Voraussetzung für ein gleichmäßiges Spritzbild, deshalb lässt sich keine scharf abgrenzende Lackierkante ausbilden.

Ein Lackierbild mit exakter Begrenzung der Lackierfläche und mit weniger Spritznebel erhält man mit sog. Airless-Sprühsystemen. Weil diese exaktes, wiederholgenaues Sprühen erfordern, werden die verwendeten Sprühventile mit Robotersystemen geführt. Die Überlappung der Sprühgänge sollte dabei möglichst klein sein, um Materialanhäufungen zu vermeiden. Im Stand der Technik sind unterschiedliche Sprühventile und Konstruktionen bekannt.

Ein bekanntes Verfahren zum Aufbringen eines Schutzlacks ist unter dem Namen "Select-Coat®-Verfahren" bekannt und beruht auf einer Schlitzdüse. Der Schutzlack wird durch diese Düse gepresst. Allerdings wird die Aufrechterhaltung des Lackfilms durch kleinste Verunreinigungen gestört. Substrate mit höheren Hindernissen, wie sie bspw. eine Flachbaugruppe darstellt, lassen sich nur unbefriedigend beschichten, weil sich hinter jedem überfahrenen Hindernis abhängig von Geschwindigkeit und Bauteilhöhe Sprühschatten ausbilden. Auch treten unter diesen Bedingungen Spritzer auf. Die Viskosität der Lacke darf 200 mPas nicht überschreiten. Ansonsten mehrt sich die Spritzerbildung.

Für höherviskose Beschichtungsmaterialien existiert ein Verfahren, das sich "Swirl-Coat-Verfahren" nennt und auf einem kreisförmig oder elliptisch bewegten Sprühstrahl beruht. Diese Methode eignet sich bei Flachbaugruppen gut für niedrig bestückte Flächen, wohingegen bei mit höheren Bauteilen bestückte Flächen sehr unterschiedliche Schichtdicken entstehen. Auch ändert sich die Auftragsbreite der Sprühfläche mit dem zwangsläufig notwendigen Wechsel des Abstandes der Düse zum Substrat. Für den Auftrag niederviskoser Stoffe und Lacke auf Flachbaugruppen ist dieses Verfahren nicht geeignet, weil sich zu große Unterschiede in der Lackhöhe ausbilden. Der Sprühkopf kann wegen seiner Größe nicht zwischen hohen Bauteilen eintauchen.

Ferner bleiben beim Lackieren Filamente an Bauteilen hängen und unterbrechen das Lackierbild und erzeugen dadurch Spritzer. Außerdem lassen sich mit diesem Verfahren Randbereiche nicht sauber beschichten.

In DE 33 29 880 A1 ist ein Sprühventil offenbart, das eine Materialdüse, die das Material am Düsenaustritt verteilt, und Luftdüsen aufweist, die den erzeugten Materialstrom fein verteilter Tröpfchen lenkt. Es entstehen der Lenkung des Luftstroms entsprechend runde oder elliptische Beschichtungsflächen, aus denen Beschichtungsbahnen gebildet werden. Der Sprühkopf kann wegen seiner Größe nicht zwischen hohen Bauteilen eintauchen. Mit dem daraus resultierenden zunehmendem Abstand verbreitet sich der Sprühstrahl und erzeugt Spritzer.

US 6,170,760 B1 offenbart eine Vorrichtung, in der die Luft in Form eines Mantels um das Beschichtungsmaterial in der Materialdüse geführt wird. Der Lack wird beim Verlassen des Sprühventils zerstäubt. Die Düse kann dünn ausgebildet sein, jedoch nicht beliebig lang, weil sich sonst der dieser Methode anhaftende Pulsationseffekt verstärkt. Auch eine zu dünne Düse (< 0,6 mm) verstärkt die Pulsation und erzeugt Spritzer. Die Pulsation entsteht, weil das Beschichtungsmaterial zur Kugelform strebt, die es im Luftstrom abhängig von Geschwindigkeit, Düsendurchmesser und Viskosität des Beschichtungsmaterials annimmt. Die beim Austritt aus der Düse expandierende Luft erzeugt bei zu dünner Düse Spritzer. Deshalb lässt sich keine schmale Beschichtungsfläche erzeugen, sondern nur ca. 20 mm breite Bahnen. Es können nur niederviskose Lacke verarbeitet werden. Bei höherviskosen Materialien erhöht sich die Pulsation, mit der Folge, dass Spritzer entstehen, weil sich in der Spritzdüse sowohl Luft als auch Stoffanhäufungen ausbilden, die zur unregelmäßigen Materialausbringung führen.

US 6,132,809 A offenbart einen drehbaren Doppelkopf, der mit einem Dispens- und einem Sprühkopf ausgestattet ist.

Obgleich sich die in der eingangs erwähnten DE 10261576 offenbarte Vorrichtung in der Praxis bewährt hat, bleibt weiterhin der Wunsch bestehen, einen verbesserten Auftrag, eine höhere Flexibilität sowie eine verbesserte Beschichtung von Randkonturen bei möglichst geringem konstruktiven Aufwand zu erreichen.

Die Aufgabe der vorliegenden Erfindung besteht nun darin, eine Vorrichtung anzugeben, der die Nachteile des Standes der Technik nicht anhaften. Die Vorrichtung soll eine hochpräzise Beschichtung insbesondere von Randkonturen zulassen und zudem eine Beschichtung ermöglichen, bei der keine Spritzer entstehen, , wobei die Verarbeitung hoch- und niederviskoser Lacke ohne Düsentausch möglich ist. Zudem soll auch eine Verteilung des Beschichtungsmaterials bspw. hinter Beinchen von Bauelementen auf einer Leiterplatte möglich sein.

Die der Erfindung zugrundeliegende Aufgabe wird von einer Vorrichtung der eingangs genannten Art dadurch gelöst, dass die Materialauftragseinrichtung ein Jetelement bzw. Jetventil aufweist, das in einem ersten Betriebsmodus eine gejettete Zuführung von Material in das innere rohrförmige Element ermöglicht.

Durch den Einsatz eines Jetelements bzw. Jetventils wird eine sehr genau Dosierung des Beschichtungsmaterials und ein hochpräziser punktgenauer Auftrag möglich, wobei die Größe der ausgebrachten Materialtropfen programmgesteuert einstellbar ist. Gerade das Beschichten von Randkonturen wird durch diese Vorrichtung deutlich verbessert, da bspw. keine Verkürzung der Raupe an Ecken entsteht. Die Materialtropfen bilden nämlich eine Raupe erst auf dem Substrat. Der konstruktive Aufwand ist überschaubar, da lediglich ein Ventil hierfür vorgesehen werden muss, das sich darüber hinaus auch für andere Auftragsarten, wie bspw. Dispensen eignet.

Zudem bringt die Vorrichtung das Beschichtungsmaterial ohne Zufuhr von Luft, d.h. nicht vernebelt bzw. atomisiert, auf das Substrat auf, wobei dieser Auftrag erst hier durch entsprechende Zuführung eines gasförmigen Mediums, insbesondere Druckluft, gleichmäßig auf dem Substrat verteilt wird. Die Verteilung des Beschichtungsmaterials erfolgt deshalb gleichmäßig, da die Luft in einem ringförmigen Zuführkanal strömt, der den Strom des Beschichtungsmaterials umgibt.

Diese Ausgestaltung lässt es ohne weiteres zu, das innere rohrförmige Element beliebig lang zu machen, so dass auch zwischen höheren Bauteilen mit sehr geringem Abstand zum Substrat beschichtet werden kann. Damit ist es möglich, nahezu spritzerlos zu beschichten.

Die Schichtdicke und Bahnbreite selbst ergibt sich aus der Materialmenge, der Materialviskosität und der Intensität der zugeführten Luft (Verdrängerluft). Beim Verdrängen der Materialtropfen oder der Materialraupe, die sich zunächst beim Auftragen des Beschichtungsmaterials bildet, entsteht ein Materialwulst, der bspw. Bauteilbeinchen auf einer Leiterplatte umhüllend beschichtet und auch im Sprühschatten liegende Bauteilbeinchen und Bauteile erreicht.

Wie bereits erwähnt, lassen sich sehr geringe Abstände zwischen Substrat und innerem rohrförmigem Element realisieren. Dieser Abstand beträgt vorzugsweise 6-10 mm. Da der Auftrag aus einem solchen Abstand nahezu spritzerfrei ist, bleiben dadurch Kontakte, wie Stecker, Schalter, etc. sicher frei von Spritzern. Die Ausbildung von abgekürzten Rundkanten an Ecken durch Nachschleppen der Raupe wird das Jetten einzelner Tropfen minimiert, unterstützt vom Verdrängerluftstrahl, der dieses Nachschleppen nahezu eliminiert.

Werden bspw. niedere Bauteile wie SMD-Bauteile beschichtet, schiebt sich der Wulst, der von der Verdrängerluft erzeugt wird, über diese Bauteile, ummantelt diese vollständig und endet in Form einer entsprechend dem zusätzlichen Materialbedarf ungeraden, aber nebel- und spritzfreien scharfen Abgrenzung der Beschichtungsfläche.

Die Vorrichtung eignet sich zur Beschichtung mit jedem fließfähigen Beschichtungsmaterial, das aus dem inneren rohrförmigen Element auf das Substrat aufgetragen werden kann. Auch für hochviskose Stoffe, mit denen sich höhere Schichtdicken erzeugen lassen, ist sie geeignet. Der Druck der Verdrängerluft wird proportional zu einem Anstieg der Viskosität erhöht.

Die erfindungsgemäße Vorrichtung ermöglich folglich einen Auftrag eines Beschichtungsmaterials (was als Sprühen bezeichnet wird) sowohl als Materialraupe (was als Dispensen bezeichnet wird) oder als Materialtropfen (was als Jetten bezeichnet wird), wobei in beiden Fällen jeweils selektiv durch den Einsatz von Luft das Material verteilt werden kann.

Eine Vorrichtung mit diesem großen Einsatzbereich und mit dieser Flexibilität ist bisher nicht auf dem Markt erhältlich.

Erfindungsgemäß sind im äußeren rohrförmigen Element mindestens drei, vorzugsweise vier oder mehr Einkerbungen vorgesehen, die sich radial nach Innen bis zum inneren rohrförmigen Element erstrecken.

Diese Ausgestaltung hat den Vorteil, dass sich das innere rohrförmige Element auf konstruktiv einfache Weise zum äußeren Element zentrieren lässt, wobei diese zentrierte Position dauerhaft gehalten wird. Darüber hinaus wirken diese Einkerbungen als Luftführungselemente, um ein laminare Strömung zu erreichen. Bisher war hierfür ein eigenes Bauelement erforderlich, das deutlich mehr Bauraum benötigte.

Das heißt, dass auch der Außendurchmesser des äußeren rohrförmigen Elements reduziert werden kann, auf vorzugsweise 2 bis 2,5 mm. Damit lassen sich auch sehr enge Räume auf einer Leiterplatte anfahren und sauber beschichten.

In einer bevorzugten Weiterbildung besitzt das innere rohrförmige Element einen dem Substrat zugewandten durchmessergleichen Endabschnitt.

Das heißt mit anderen Worten, dass sich der Endabschnitt nicht verjüngt, wie dies zur Ausbildung einer Düse im Stand der Technik vorgesehen wird. Vorzugsweise besitzt der Endabschnitt des äußeren rohrförmigen Elements einen Durchmesser von etwa 2 bis 5 mm, vorzugsweise 2,5 mm und der Endabschnitt des inneren rohrförmigen Elements bis ca. 0,8 mm.

Diese Maßnahme hat den Vorteil, dass die beiden rohrförmigen Elemente sehr gut auch zwischen sehr dicht beieinander stehenden Bauteilen auf einer Leiterplatte eintauchen können.

Es ist jedoch auch denkbar, den Endabschnitt des inneren rohrförmigen Elements konisch auszubilden, so dass der Innendurchmesser zur Öffnung hin abnimmt. Hiermit lässt sich der Jeteffekt verstärken.

In einer bevorzugten Weiterbildung ist eine Einrichtung zur Erwärmung des Beschichtungsmaterials vorgesehen, um einen konstanten Materialfluss zu gewährleisten.

In einer bevorzugten Weiterbildung ist eine Wärmeeinrichtung zum Erwärmen des gasförmigen Mediums vorgesehen, wobei das erwärmte Medium bei seinem Weg durch das äußere rohrförmige Element das Beschichtungsmaterial in dem inneren rohrförmigen Element erwärmt.

Diese Maßnahme hat den Vorteil, dass die Viskosität des zuvor schon erwärmten Beschichtungsmaterials auch in der inneren Röhre konstant gehalten werden kann, indem ihm eine entsprechende Wärme zugeführt wird. Damit lässt sich ein reproduzierbares Lackbild erzielen.

In einer bevorzugten Weiterbildung ist eine Einrichtung zum Schmelzen des Beschichtungsmaterials vorgesehen, um Schmelzlacke zu beschichten, die durch Abkühlen härten. Die Einrichtung kann zum Schmelzen bspw. heiße Luft (180°) verwenden.

In einer bevorzugten Weiterbildung ist dem äußeren rohrförmigen Element ein Ventil zugeordnet, um den Strom des gasförmigen Mediums durch das Element zu unterbrechen.

Diese Maßnahme bewirkt, dass ein dicker Überzug in Form einer Materialraupe erzielt werden kann, indem die Verdrängerluft abgestellt, d.h. unterbrochen wird. Damit können Bereiche wie bspw. Beinchenreihen von ICs etc. mit ein und derselben Ausführung (der inneren und äußeren Röhre) besonders geschützt werden.

In einer bevorzugten Weiterbildung ist zur Steuerung der Verdrängerluft ein Ventil, vorzugsweise ein Proportionalventil vorgesehen, das prozessgesteuert den Luftdruck variiert.

In einer bevorzugten Weiterbildung weist die Gas-Zuführeinrichtung eine Beimengungseinheit auf, um dem gasförmigen Medium ein pulverförmiges Material beizumengen.

Dies hat den Vorteil, dass die Eigenschaften des Beschichtungsmaterials verändert werden können.

Die erfindungsgemäße Vorrichtung führt ein Verfahren aus, das die folgenden Schritte aufweist:
- Auftragen des Beschichtungsmaterials auf das Substrat derart, dass eine Raupe oder ein Materialtropfen gebildet wird, und
- Beaufschlagen der Raupe bzw. des Materialtropfens mit einem Strahl eines gasförmigen Mediums, so dass die Raupe bzw. der Materialtropfen verdrängt und flächig verteilt wird.

Dieses Verfahren führt zu den bereits erwähnten Vorteilen, so dass auf deren Wiederholung verzichtet werden kann.

Bevorzugt wird das gasförmige Medium koaxial zu dem Beschichtungsmaterial geführt. Bei dem gasförmigen Medium kann es sich bspw. um ein Inertgas handeln, was den Vorteil hat, dass ein unerwünschtes Antrocknen des Beschichtungsmaterials an dem inneren rohrförmigen Element verhindert wird.

Weitere Vorteile und Ausgestaltungen der Erfindung ergeben sich aus der Beschreibung und der beiliegenden Zeichnung.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind.

Die Erfindung wird nun an Hand eines Ausführungsbeispiels unter Bezugnahme auf die Zeichnung näher erläutert. Dabei zeigen:
- Figur 1: eine schematische Darstellung einer Vorrichtung zum Beschichten eines Substrats in einer Seitenansicht dargestellt, und
- Figur 2: eine Schnittansicht des unteren Endes der rohrförmigen Elemente.

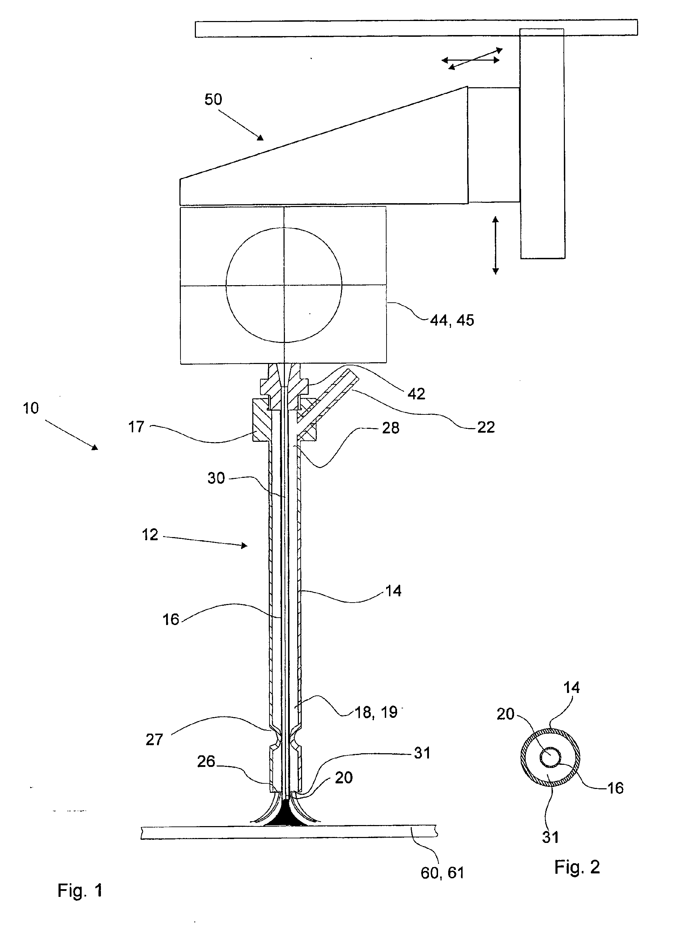

In Figur 1 ist der Düsenbereich (Beschichtungskopf) einer Beschichtungsanlage dargestellt und mit dem Bezugszeichen 10 gekennzeichnet. Eine Beschichtungsanlage wird bspw. dazu benutzt, einen Schutzlack auf eine Leiterplatte aufzutragen, um die Leiterbahnen bspw. gegen Feuchtigkeit zu schützen.

Die Beschichtungsanlage umfasst eine Düseneinrichtung 12, die im Wesentlichen aus zwei Röhren 14, 16 aufgebaut ist, die jeweils an einem Ende 28 mit einem Kopfteil 17, 42 enden. Die Röhre 14 liegt außen (nachfolgend äußere Röhre genannt) und umgibt die innere Röhre 16. Beide Röhren 14, 16 sind koaxial zueinander angeordnet, so dass sich zwischen der inneren Röhre 16 und der äußeren Röhre 14 ein Ringbereich 18 ausbildet. Die mechanische Verbindung der beiden Röhren 14, 16 kann bspw. durch Verschrauben der beiden Kopfteile 17, 42 erfolgen.

Wie sich aus Figur 1 ergibt, endet die innere Röhre 16 versetzt zu der äußeren Röhre 14, so dass sich ein vorstehender Endabschnitt 20 ergibt.

An der äußeren Röhre 14 sind in ihrem unteren Bereich Einkerbungen 27 vorgesehen, die sich radial nach Innen in Richtung der inneren Röhre 16 erstrecken. Die Einkerbungen dienen einerseits dazu, die innere Röhre zentrisch zu der äußeren Röhre zu halten. Um dies sicher zu erreichen, sind vorzugsweise drei oder mehr Einkerbungen vorgesehen, die gleichmäßig über den Umfang verteilt sind.

Andererseits dienen diese Einkerbungen 27 als Luftführungselemente, um die Strömung des gasförmigen Mediums zum offenen Ende 26 des Ringkanals laminar, d.h. frei von Wirbeln, zu machen.

Am Kopfteil 17 der äußeren Röhre 14 ist eine röhrenförmige Zuführung 22 angebracht, die in den Ringbereich 18 mündet. Über diese Zuführung 22 lässt sich ein gasförmiges Medium in den Ringbereich 18 leiten. Innerhalb dieses Ringbereichs 18, der einen Ringkanal 19 bildet, kann ein Strömungselement angeordnet sein, das die Strömung des gasförmigen Mediums laminar macht. Bevorzugt wird ein solches Strömungselement aber weggelassen, da die Einkerbungen 27 diese Funktion erfüllen können. Das dem offenen Ende 26 gegenüberliegende Ende 28 des Ringkanals 19 ist geschlossen, so dass an dieser Stelle das gasförmige Medium nicht austreten kann. Obgleich in der Figur das offene Ende 26 der äußeren Röhre 14 den gleichen Durchmesser wie der Ringkanal besitzt, ist es auch denkbar, den Durchmesser zu reduzieren, um auf diese Weise die ausströmende Luft dichter an der inneren Röhre strömen zu lassen.

Die innere Röhre 16 bildet ebenfalls einen Kanal 30 aus, der sich koaxial zum Ringkanal 19 erstreckt und ebenfalls am Endabschnitt 20 offen ist. Am Endabschnitt 20 ergeben sich folglich zwei Öffnungen, nämlich eine kreisförmige Öffnung der inneren Röhre 16, aus der das Beschichtungsmaterial austreten kann und eine ringförmige Öffnung 31, die koaxial und symmetrisch (konzentrisch) zu der kreisförmigen Öffnung liegt und aus der das gasförmige Medium austreten kann. In Figur 2 ist dies nochmals schematisch dargestellt.

Am gegenüberliegenden Ende der inneren Röhre 16 ist das Kopfteil 42 vorgesehen, das mit der Materialzufuhr in Form einer Ventileinrichtung 44 verbunden ist. Diese Ventileinrichtung 44 umfasst ein Jetventil 45. Ein solches Jetventil ermöglich das getaktete Zuführen von Material in sehr geringen Mengen, so dass ein Austrag von kleinen Materialtropfen in schneller Abfolge stattfinden kann. Ferner ist das Kopfteil 42 in das Kopfteil 17 der äußeren Röhre 14 eingesteckt bzw. verschraubt. Die Ventilvorrichtung 44 und insbesondere das Jetventil 45 ist dafür vorgesehen, die Zufuhr eines Beschichtungsmaterials in den Kanal 30 zu steuern. Auch das über die Zuführung 22 zugeführte gasförmige Medium wird über ein nicht dargestelltes Ventil gesteuert.

Die Düseneinrichtung 12 ist an einem Antrieb 50 angebracht, der in der Figur nur schematisch angedeutet ist, und eine Bewegung der Düseneinrichtung 12 in mehreren Dimensionen zulässt. Die in der Figur gezeigten Pfeile deuten die Bewegungsrichtungen an. Neben diesen translatorischen Bewegungen sind auch Schwenkbewegungen möglich.

Das Aufbringen eines Beschichtungsmaterials auf ein Substrat 60, bspw. eine Leiterplatte 61, lässt sich nun wie folgt durchführen:
Aus einem unter Luftdruck stehenden Vorratsbehälter oder mittels programmgesteuerter Pumpe, die in der Figur nicht dargestellt sind, wird das Beschichtungsmaterial, bspw. ein Schutzlack, über das Jetventil 45 in den Kanal 30 der inneren Röhre 16 geführt. Am Endabschnitt 20 tritt das Beschichtungsmaterial in Form eines Strahls oder in Form von Tropfen aus und bildet eine Raupe auf der Leiterplatte 61, wenn die Düseneinrichtung 12 sich relativ zu der Leiterplatte 61 bewegt. Um diese Raupe auf der Leiterplatte 61 flächig zu verteilen, wird in die Zuführung 22 Luft oder ein Inertgas eingeführt, das durch den Ringkanal 19 strömt und am offenen Ende 26 der äußeren Röhre 14 austritt. Aufgrund der koaxialen Anordnung der beiden Röhren 14, 16 strömt die Luft parallel zu dem Beschichtungsmaterialstrahl und verdrängt das Beschichtungsmaterial beim Auftreffen auf die Leiterplatte 61. Durch entsprechende Einstellung des Materialdrucks, des Luftdrucks und der Luftmenge kann die Art der Verdrängung auf der Leiterplatte 61 eingestellt werden.

Die Zufuhr von Luft kann über das Absperrventil unterbrochen werden, falls es notwendig ist, eine dickere Materialschicht auf der Leiterplatte 61 aufzutragen (zu dispensen).

Das Unterbrechen des Materialstroms durch den Kanal 30 muss so erfolgen, dass kein Druck auf das in dem Kanal befindliche Material mehr ausgeübt wird, um auf diese Weise ein Nachtropfen zu verhindern. Dies bewirkt der dichte Verschluss des Jetventils 45.

Neben der Beschickung des Kanals 30 mit Beschichtungsmaterial über einen unter Druck stehenden Vorratsbehälter ist es auch denkbar, eine Dosierpumpe anzuordnen, die aus einem Vorratsbehälter Beschichtungsmaterial in den Kanal 30 führt. Die Dosierpumpe kann proportional zur Geschwindigkeit des Antriebs gesteuert sein.

Auf Grund der geringen Abmessungen der Düseneinrichtung 12, der Außendurchmesser der äußeren Röhre beträgt bspw. nur 2 bis 5 mm, vorzugsweise 2,5 mm, lässt sich der Endabschnitt 20 der inneren Röhre 16 auch bei dicht nebeneinander angeordneten Bauelementen auf der Leiterplatte 61 sehr nahe an diese heranfahren oder zwischen diesen hindruchfahren, bspw. bei einer Distanz zur Leiterplatte von 6 bis 10 mm. Damit lassen sich Spritzer sehr wirkungsvoll vermeiden.

Darüber hinaus handelt es sich bei den die Kanäle bildenden Röhren um einfache Bauelemente, so dass eine kostengünstige Realisierung der Düseneinrichtung 12 möglich wird.

## Patentansprüche

1. Vorrichtung zum Beschichten eines Substrats (60), insbesondere einer Leiterplatte (61), mit einer Einrichtung (16) zum Auftragen eines Beschichtungsmaterials, Materialauftragseinrichtung, und einer Einrichtung (14) zum Zuführen eines gasförmigen Mediums, Gas-Zuführeinrichtung, wobei die Materialauftragseinrichtung ein inneres rohrförmiges Element (16) aufweist, wobei die Gas-Zuführeinrichtung ein äußeres rohrförmiges Element (14) aufweist, das koaxial zu dem inneren rohrförmigen Element (16) angeordnet ist und dieses umschließt, so dass ein Gas-Zuführkanal (19) zwischen äußerem und innerem rohrförmigen Element (14, 16) ausgebildet wird, der an einem Ende (26) eine ringförmige Öffnung (31) aufweist, wobei der Zuführkanal (19) so ausgestaltet ist, dass das gasförmige Medium parallel zu dem Beschichtungsmaterial durch die ringförmige Öffnung (31) ausströmt, um beim Auftreffen auf dem Substrat (60) das aufgebrachte Beschichtungsmaterial zu verdrängen und dadurch flächig zu verteilen, **dadurch gekennzeichnet, dass**
die Materialauftragseinrichtung ein jetventil (45) aufweist, das in einem ersten Betriebsmodus eine gejettete Zuführung von Material in das innere rohrförmige Element (16) durchführt,
das jetventil (45) ausgelegt ist, in einem zweiten Betriebsmodus zu arbeiten,
bei dem Material unterbrechungsfrei zugeführt wird, wobei in beiden Betriebsmodi ein gasförmiges Medium, vorzugsweise Luft, zuführbar ist, und
das äußere rohrförmige Element (14) zumindest drei, vorzugsweise vier oder mehr, Einkerbungen aufweist, die sich radial nach innen bis zum inneren rohrförmigen Element (16) erstrecken.

2. Vorrichtung nach einem der vorhergehenden Ansprüche, **dadurch gekennzeichnet, dass** das innere rohrförmige Element (16) einen dem Substrat zugewandten durchmessergleichen Endabschnitt besitzt.

3. Vorrichtung nach Anspruch 1, **dadurch gekennzeichnet, dass** das innere rohrförmige Element (16) einen dem Substrat zugewandten Endabschnitt aufweist, dessen Durchmesser sich verjüngt.

4. Vorrichtung nach einem der vorhergehenden Ansprüche, **dadurch gekennzeichnet, dass** der Endabschnitt des äußeren rohrförmigen Elements (14) einen Durchmesser von etwa 2 bis 5 mm besitzt.

5. Vorrichtung nach einem der vorhergehenden Ansprüche, **dadurch gekennzeichnet, dass** eine Wärmeeinrichtung zum Erwärmen des gasförmigen Mediums vorgesehen ist, wobei das erwärmte Medium bei seinem Weg durch das äußere rohrförmige Element (14) das erwärmte Beschichtungsmaterial in dem inneren rohrförmigen Element am Abkühlen hindert.

6. Vorrichtung nach einem der vorhergehenden Ansprüche, **dadurch gekennzeichnet, dass** die Gas-Zuführeinrichtung eine Beimengungseinheit aufweist, um dem gasförmigen Medium ein pulverförmiges Material beizumengen.

7. Vorrichtung nach einem der vorhergehenden Ansprüche, **dadurch gekennzeichnet, dass** sie in zumindest zwei Richtungen (x-, y-Achse) verfahrbar ausgebildet ist.

8. Vorrichtung nach Anspruch 7, **dadurch gekennzeichnet, dass** sie schwenkbar ausgebildet ist.

9. Vorrichtung nach einem der vorhergehenden Ansprüche, **dadurch gekennzeichnet, dass** ein Mittel zur Erwärmung des Beschichtungsmaterials vor dessen Applikation vorgesehen ist.

10. Vorrichtung nach einem der vorhergehenden Ansprüche, **dadurch gekennzeichnet, dass** das Beschichtungsmaterial ein aufgeschmolzenes thermoplastisches Material, Schmelzharz, ist.

## Claims

1. An apparatus for the coating of a substrate (60), in particular of a circuit board (61), with a device (16) for applying a coating material, material application device, and with a device (14) for supplying a gaseous medium ,gas supply device, the material application device having an inner tubular element (16), the gas supply device having an outer tubular element (14) which is arranged coaxially to the inner tubular element (16) and surrounds the latter, so as to form, between the outer and the inner tubular element (14, 16), a gas supply duct (19) which has an annular orifice (31) at one end (26), the supply duct (19) being configured so that the gaseous medium flows out, parallel to the coating material, through the annular orifice (31), in order, when it impinges on the substrate (60), to displace the applied coating material and thereby distribute it over the area, **characterized in that** the material application device has a jet valve (45) which, in a first operating mode, carries out a jetted supply of material into the inner tubular element (16),
the jet valve (45) is designed to operate in a second operating mode in which material is supplied uninterruptedly, wherein a gaseous medium, preferably air, can be supplied in both operating modes, and
the outer tubular element (14) has at least three, preferably four or more indentations which extend radially inward as far as the inner tubular element (16).

2. The apparatus as claimed in one of the preceding claims, **characterized in that** the inner tubular element (16) possesses an end portion of identical diameter which faces the substrate.

3. The apparatus as claimed in claim 1, **characterized in that** the inner tubular element (16) has an end portion which faces the substrate and the diameter of which tapers.

4. The apparatus as claimed in one of the preceding claims, **characterized in that** the end portion of the outer tubular element (14) possesses a diameter of about 2 to 5 mm.

5. The apparatus as claimed in one of the preceding claims, **characterized in that** a heating device for heating the gaseous medium is provided, the heated medium, on its way through the outer tubular element (14), preventing the heated coating material in the inner tubular element from cooling.

6. The apparatus as claimed in one of the preceding claims, **characterized in that** the gas supply device has an admixing unit in order to admix a pulverulent material to the gaseous medium.

7. The apparatus as claimed in one of the preceding claims, **characterized in that** it is designed to be movable in at least two directions (x-axis, y-axis).

8. The apparatus as claimed in claim 7, **characterized in that** it is designed to be pivotable.

9. The apparatus as claimed in one of the preceding claims, **characterized in that** a means for heating the coating material before the application of the latter is provided.

10. The apparatus as claimed in one of the preceding claims, **characterized in that** the coating material is a melted thermoplastic material, melt resin.

## Revendications

1. Dispositif de revêtement d'un substrat (60), en particulier d'une carte à circuits imprimés (61), comprenant un dispositif (16) pour appliquer un matériau de revêtement, ou dispositif d'enduction de matériau, et un dispositif (14) pour distribuer un milieu gazeux, ou dispositif d'alimentation en gaz, le dispositif d'enduction de matériau présentant un élément interne tubulaire (16), le dispositif d'alimentation en gaz présentant un élément externe tubulaire (14), lequel est disposé coaxialement par rapport à l'élément interne tubulaire (16) et entoure celui-ci, de telle sorte qu'un canal d'alimentation en gaz (19) soit réalisé entre l'élément tubulaire externe et l'élément tubulaire interne (14, 16), lequel canal d'alimentation en gaz présente, au niveau d'une extrémité (26), une ouverture annulaire (31), le canal d'alimentation (19) étant configuré de telle sorte que le milieu gazeux s'écoule parallèlement au matériau de revêtement à travers l'ouverture annulaire (31), afin de déplacer le matériau de revêtement appliqué et de ce fait de le répartir à plat lors de son incidence sur le substrat (60), **caractérisé en ce que**
le dispositif d'enduction de matériau présente une soupape à jet (45) qui, dans un premier mode de fonctionnement, effectue une alimentation par injection de matériau dans l'élément interne tubulaire (16),
la soupape à jet (45) est conçue pour fonctionner dans un deuxième mode de fonctionnement, dans lequel le matériau est alimenté sans interruption, un milieu gazeux, de préférence de l'air, pouvant être distribué dans les deux modes de fonctionnement et
l'élément externe tubulaire (14) présente au moins trois, de préférence quatre ou plus de quatre, encoches qui s'étendent radialement vers l'intérieur jusqu'à l'élément interne tubulaire (16).

2. Dispositif selon la revendication précédente, **caractérisé en ce que** l'élément interne tubulaire (16) possède une portion d'extrémité de diamètre égal tournée vers le substrat.

3. Dispositif selon la revendication 1, **caractérisé en ce que** l'élément interne tubulaire (16) présente une portion d'extrémité tournée vers le substrat dont le diamètre se rétrécit.

4. Dispositif selon l'une quelconque des revendications précédentes, **caractérisé en ce que** la portion d'extrémité de l'élément externe tubulaire (14) possède un diamètre d'environ 2 à 5 mm.

5. Dispositif selon l'une quelconque des revendications précédentes, **caractérisé en ce qu'**un dispositif de chauffage pour chauffer le milieu gazeux est prévu, le milieu chauffé, lors de sa trajectoire à travers l'élément externe tubulaire (14), empêchant le refroidissement du matériau de revêtement chauffé dans l'élément interne tubulaire.

6. Dispositif selon l'une quelconque des revendications précédentes, **caractérisé en ce que** le dispositif d'alimentation en gaz présente une unité de mélange afin de mélanger un matériau pulvérulent au milieu gazeux.

7. Dispositif selon l'une quelconque des revendications précédentes, **caractérisé en ce qu'**il est réalisé de manière à pouvoir être déplacé dans au moins deux directions (axes x, y).

8. Dispositif selon la revendication 7, **caractérisé en ce qu'**il est réalisé sous forme pivotante.

9. Dispositif selon l'une quelconque des revendications précédentes, **caractérisé en ce qu'**il est prévu un moyen pour chauffer le matériau de revêtement avant son application.

10. Dispositif selon l'une quelconque des revendications précédentes, **caractérisé en ce que** le matériau de revêtement est un matériau thermoplastique en fusion, ou résine thermofusible.
